# EUROPÄISCHE PATENTSCHRIFT

(11) **EP 2 251 701 B1**
(45) Veröffentlichungstag und Bekanntmachung des Hinweises auf die Patenterteilung: **02.09.2015**
(21) Anmeldenummer: 10003721.7
(22) Anmeldetag: 07.04.2010
(51) Int. Cl.: G01R 15/09, G01R 29/08

(54) **Verfahren zur Gewinnung einer Feldstärkeinformation**
Method for extracting field strength information
Procédé de production d'une information sur l'intensité de champ

(30) Priorität: 13.05.2009 DE 102009021153; 13.05.2009 US 177805 P
(43) Veröffentlichungstag der Anmeldung: 17.11.2010
(73) Patentinhaber: Atmel Corporation, San Jose, CA 95110 (US)
(72) Erfinder: Moser, Daniel, Dipl.-Ing., 70825 Korntal-Münchingen (DE); Saile, Thomas, Dipl.-Ing., 74670 Forchtenberg (DE)
(74) Vertreter: Grünecker Patent- und Rechtsanwälte PartG mbB

(56) Entgegenhaltungen:
- DE-A1- 1 906 756
- US-A- 4 382 227

## Beschreibung

Die vorliegende Erfindung betrifft ein Verfahren zur Gewinnung einer Feldstärkeinformation, gemäß dem Oberbegriff des Patentanspruchs 1 und eine Schaltungsanordnung gemäß dem Oberbegriff des Patentanspruchs 7.

Ein derartiges Verfahren ist aus der Druckschrift EP 1 318 623 B1 bekannt. Unter anderem wird mittels der Feldstärkeinformation eine Entfernungsbestimmung zwischen Sender und Empfänger möglich und kann als Mittel zur Erkennung einer Weiterleitung eingesetzt werden. Im Allgemeinen wird aus der empfangenen Signalstärke ein sogenannter "RSSI-(Received Signal Strength Indicator)" Wert bestimmt, der zu dem Eingangssignal einer Empfangsantenne in Zusammenhang steht. Dabei wird aus einem empfangenen elektromagnetischen Signal mittels einer Empfangseinheit mit einem Eingangswiderstand eine Eingangsspannung für einen Operationsverstärker erzeugt und von dem Operationsverstärker mittels eines festen Verstärkungsfaktors eine Ausgangsspannung bereitgestellt.
Die Eingangsspannung am Operationsverstärker wird solange verändert, bis die Ausgangsspannung innerhalb eines vorgegebenen, den Wert der Referenzspannung einschließenden Intervalls liegt. Hierzu wird die Eingangsspannung an dem Teilerknoten eines Spannungsteilers abgegriffen und zur Anpassung der Ausgangsspannung an die Referenzspannung der Widerstand des Spannungsteilers mittels einer Zuschaltung oder Wegschaltung von zueinander in einer aufwändigen Parallelschaltung verbundenen Widerstandszweigen verändert.
Des Weiteren wird das Verfahren verwendet, um aus den ermittelten Feldstärkewerten die Entfernung der Empfangseinheit von einer Sendeeinheit zu bestimmen. Durch die fest vorgegebenen Werte der Widerstandszweige der Parallelschaltung ist die Ortsauflösung in Abhängigkeit der Entfernung sehr unterschiedlich, insbesondere ist bei einem geringen Abstand die Ortsauflösung unzureichend. Des Weiteren ändert sich der Gesamtwiderstand in Abhängigkeit des ausgewählten Parallelwiderstands. Hierdurch ändert sich die Belastung eines vorgeschalteten Antennenkreises. Durch die Belastungsänderung wiederum ändert sich die Impedanz des Anntennenkreises und bei einer induktiven Kopplung erfolgt zusätzlich eine Rückwirkung auf den Sendekreis eines Senders statt.

Unter anderem werden Verfahren zur Gewinnung einer Feldstärkeinformation bei Systemen für eine kontaktlose Datenübertragung verwendet. Ein wichtiger Anwendungsbereich stellen Identifikationssysteme dar, die beispielsweise in einem Kraftfahrzeug bei der Zugangskontrolle eingesetzt werden. Derartige Identifikationssysteme bestehen aus einer Basiseinheit und einem oder mehreren Transpondern, wobei derartige Verfahren zu Bestimmung der Feldstärkewerte bzw. der Entfernung bevorzugt in den Transpondern eingesetzt werden, die beispielsweise passiv ausgeführt sind und die zum Betrieb notwendige Energie durch Absorption aus dem elektromagnetischen Feld der Basisstation beziehen müssen.

Aus der DE 190 675 6 und der US 438 2227 A sind Schaltungsanordnungen und Verfahren unter anderem zur automatischen Messbereichungsumschaltungen bekannt. Hierbei wird in der DE 190 675 6 mittels eines Stellgliedes die an einem Operationsverstärker anliegende Eingangsspannung eingestellt.

Aufgabe der vorliegenden Erfindung ist es, ein Verfahren anzugeben, mittels dessen sich die Feldstärke eines Eingangssignals vorteilhaft bestimmen lässt. Weitere Aufgabe der vorliegenden Erfindung ist es eine Schaltungsanordnung zur Durchführung des Verfahrens anzugeben.

Die erstgenannte Aufgabe wird durch die Merkmale des Patentanspruches 1 gelöst. Die zweitgenannte Aufgabe wird durch die Merkmale des Patentanspruches 7 gelöst. Günstige Ausgestaltungsformen sind Gegenstand von Unteransprüchen.

Gemäß einem ersten Aspekt der vorliegenden Erfindung wird ein Verfahren zur Gewinnung einer Feldstärkeinformation aus einem empfangenen elektromagnetischen Signal mittels einer Empfangseinheit bereitgestellt, wobei in der Empfangseinheit aus dem empfangenen Signal mittels eines als eine Spannungsteilerschaltung ausgebildeter Eingangswiderstands eine Eingangsspannung für einen Operationsverstärker erzeugt und von dem Operationsverstärker mittels eines festen Verstärkungsfaktor eine Ausgangsspannung erzeugt wird. Die Eingangsspannung wird verändert, bis die Ausgangsspannung innerhalb eines vorgegebenen, den Wert der Referenzspannung einschließenden Intervalls liegt. Hierzu wird die Eingangsspannung an der Spannungsteilerschaltung abgegriffen und zur Veränderung der Eingangsspannung an der Spannungsteilerschaltung, die eine Vielzahl von Teilerknoten und einen konstanten Widerstandswert aufweist, wird ein entsprechender Teilerknoten ausgewählt und eine Teilspannung abgegriffen. Indem jedem Teilerknoten ein vorgegebener Wert einer ersten Variablen zugeordnet ist, lässt sich aus einem Vergleich des dem ausgewählten Teilerknoten zugeordneten Wertes der ersten Variablen mit einem in einer Wertetabelle dem Wert der ersten Variable zugeordneten Feldstärkewert, der von der Empfangseinheit empfangene Feldstärkewert bestimmen.

Gemäß einem zweiten Aspekt der Erfindung wird eine Schaltungsanordnung zur Durchführung des Verfahrens bereitgestellt, aufweisend eine Empfangseinheit zum Empfangen eines elektromagnetischen Signal, die einen als Spannungsteilerschaltung ausgebildeten Eingangswiderstand und einen Operationsverstärker mit einem festen Verstärkungsfaktor umfasst, wobei der Eingang des Operationsverstärkers mit der Spannungsteilerschaltung verbunden ist und der Operationsverstärker aus einer anliegenden Eingangsspannung eine Ausgangsspannung bereitstellt. Ferner umfasst die Empfangseinheit ein mit dem Ausgang des Operationsverstärkers verbundenes Stellglied, mit einem Eingang für die Ausgangsspannung und einem Eingang für eine Referenzspannung. Die Spannungsteilerschaltung weist einem konstanten Widerstandswert auf und umfasst eine Vielzahl von zueinander in Serie liegenden Teilerknoten. Ferner ist das Stellglied eingerichtet, zur Veränderung der Eingangsspannung eine in Abhängigkeit eines Vergleichs der Ausgangsspannung mit der Referenzspannung ein Steuersignal zur Auswahl der Teilerknoten bereitzustellen, und ist für die Ermittlung der empfangenen Feldstärke eingerichtet, an einem Ausgang ein dem Steuersignal zugeordnetes Signal bereitzustellen, wobei der Wert des Signals von der empfangenen Feldstärke abhängt.

Ein Vorteil des Verfahrens bzw. der Schaltungsanordnung ist es, dass sich auf einfache Weise aus einem Vergleich des ausgewählten Teilerknotens und gespeicherten, dem jeweiligen Teilerknoten bereits vorab zugeordneten Feldstärkewert, die Feldstärke des jeweilig empfangenen elektromagnetischen Signals auf einfache Weise, vorzugsweise ohne weitere Berechnungen bestimmen lässt. Hierdurch lässt sich das Verfahren zur Bestimmung des räumlichen Abstandes d.h. der Entfernung zwischen der Empfangseinheit und einer Sendeeinheit verwenden, indem die in der Wertetabelle den der jeweiligen Teilerknoten zugeordneten Feldstärkewerte mit einem Abstandswert verknüpft werden. Ferner lässt sich mittels den derart bestimmten Werten für die Feldstärke bzw. der Entfernung die Datenrate verändern, beispielsweise mit der Verringerung der Entfernung erhöhen und vice versa. Des Weiteren ist das Verfahren durch den geringen Stromverbrauch besonders geeignet, um bei passiven Transpondern eine Feldstärkeinformation zu gewinnen. Dem erfindungsgemäßen Verfahren liegt unter anderem zu Grunde, dass die Feldstärke mit dem Abstand zwischen einer Empfangsstation und einer Sendestation durch einen nichtlinearen funktionalen Zusammenhang verknüpft ist. Der nichtlineare Zusammenhang lässt sich Wesentlichen umgekehrt proportional durch die geeignete Ausbildung von unterschiedlichen Widerstandswerten zwischen den jeweiligen Teilerknoten der Spannungsteilerschaltung verschalteten Bauelementen kompensieren. Hierbei werden die Daten der verschalteten Bauelemente entsprechend vorab bestimmt, um den beschriebenen funktionalen Zusammenhang zwischen Feldstärke und Entfernung so nachzubilden, so dass sich möglichst eine Gerade bei einer vorzugsweise linearen Auftragung der Teilerknotennummer über dem Logarithmus der Entfernung zwischen dem Empfänger und der Basisstation ergibt. Da die Verstärkung des Operationsverstärkers konstant bleibt, weist die Ausgangsspannung des Operationsverstärkers zur Eingangsspannung ein festes Verhältnis auf. Hierdurch wird weder bei kleinen Eingangsspannungen noch bei großen Eingangsspannungen die Verstärkung erhöht und das Verhältnis von Signalspannung zu Rauschspannung bleibt im gesamten Verstärkungsbereich gering. Ein weiterer wichtiger Vorteil besteht darin, dass über den gesamten detektierbaren Entfernungsbereich eine nahezu gleichmäßige Ortsauflösung sowohl bei geringen Entfernungen zur Sendestation als auch bei großen Entfernungen der Sendestation gegeben ist.

Ein anderer Vorteil ist, dass sich bei der Veränderung der Eingangsspannung der Wert des Eingangswiderstandes der Spannungsteilerschaltung nicht verändert. Die Spannungsteilerschaltung wirkt vergleichbar zu einem Potentiometer mit einem Mittelabgriff. Es versteht sich, dass der Eingangswiderstand des Operationsverstärkers sehr hoch ist, so dass der Strom, der aus einem ausgewählten mit dem Operationsverstärker verbundenen Knoten fließt, vernachlässigbar klein ist.

Insgesamt wird eine Laständerung an einem vor der Empfängerschaltung vorgeschalteten Antennenkreis vermieden. Insbesondere wird bei der Verwendung in einem Transponder die Eingangsspannungsquelle, also der Antennenkreis konstant belastet und insbesondere die Güte des Antennenkreises nicht verändert. Dies ist bei einem induktiv gekoppelten Antennenkreis ein wichtiger Vorteil. Untersuchungen der Anmelderin haben gezeigt, dass sich die Spannungsteilerschaltung, d.h. der Eingangswiderstand sehr hochohmig ausführen lässt. Gerade bei Schaltungen die passiv arbeiten, d.h. die zur benötigten Leistung ausschließlich aus dem elektromagnetischen Feld einer Sendestation entnehmen, ist dies vorteilhaft, um die Kommunikationsreichweite zwischen einem Empfänger der nach dem erfindungsgemäßen Verfahren arbeitet, zu erhöhen.

Ferner wird insbesondere bei wechselnden Signalhöhen ein schnelles An- und Abschwingen am Ausgang des Operationsverstärkers erreicht, da die Ausgangsspannung und die Eingangsspannung des Operationsverstärkers nur wenig schwankt und die am Eingang bzw. Ausgang des Operationsverstärkers vorhandenen Kapazitäten nicht umgeladen und sich der Stromverbrauch der Schaltungseinheit sich verringert. Insbesondere bei Puls-Pausen modulierten Signalen lässt durch das kurze An- und Abschwingen die Feldlücke verringern und die Datenrate erhöhen. Ein weiterer Vorteil des festen Verstärkungsfaktors ist es, dass bei dem Operationsverstärker mittels einer hochohmigen Gegenkopplung die Verstärkung präzise mit einer geringen Stromaufnahme einstellbar ist.

In einer Weiterbildung ist vorgesehen, dass der Abgriff der Teilspannung mittels eines dem Teilerknoten zugeordneten steuerbaren Schaltmittels durchgeführt wird. Als Schaltmittel eignen sich insbesondere MOS-Transistoren. Untersuchungen der Anmelderin haben gezeigt, dass die Ansteuerung des Schaltmittels bevorzugt mittels eines Ausgangssignals eines Bauelementes eines Zählers bewirkt wird, wobei an einen weiteren Ausgang des Zählers ein der empfangenen Feldstärke zugeordnetes Signal zur Verfügung gestellt wird. Hierbei weist der Zähler vorzugsweise eine zu der Anzahl der Knoten bzw. der Schaltmittel korrespondierende Anzahl von Bauelementen auf.

In einer anderen Weiterbildung ist die Spannungsteilerschaltung als eine Reihenschaltung von einer Vielzahl von Bauelementen ausgeführt. Vorzugsweise ist die Spannungsteilerschaltung aus einer Reihenschaltung von MOS-Transistoren, vorzugsweise NMOS-Transistoren, oder passiven Widerständen ausgebildet. Bei der Ausführung als MOS-Transistoren werden die Steuereingänge, d.h. die Gates der Transistoren insgesamt verbunden. Es ist vorgesehen die Gatespannung der Transistoren derart einzustellen, so dass für den gesamten Spannungsbereich von UIN der Arbeitspunkt der MOS-Transistoren im linearen Bereich des Ausgangskennlinienfeldes liegt und hierdurch ein mit einem ohmschen Widerstand vergleichbares Verhalten vorliegt.

Indem sich die Spannungsteilerschaltung und die zugehörigen Schaltmittel, zum Verbinden des Eingangs des Operationsverstärkers zu dem entsprechend der empfangenen Feldstärke auszuwählenden Knoten, jeweils nur geringe Kapazitäten aufweisen und einen sehr geringen Strom benötigen, lässt sich mit dem erfindungsgemäßen Verfahren und der zugehörigen Schaltungsanordnung auch starke Schwankungen der empfangenen Feldstärke schnell zuverlässig erkennen und auch bei bewegten Objekten die Entfernung schnell und zuverlässig bestimmen. Anders ausgedrückt weist die Schaltungsanordnung insbesondere aufgrund der geringen Kapazitäten eine hohe Umschaltfrequenz auf, d.h. Änderungen der empfangenen Feldstärke werden mittels des Stellgliedes schnell und zuverlässig ausgeregelt und anschließend die empfangene Feldstärke bestimmt.

Gemäß einer anderen Weiterbildung ist es vorteilhaft, dass jeweils zwei zueinander ins Verhältnis gesetzte Widerstandswerte zwischen zwei Teilerknoten ein logarithmisches Verhältnis ausbilden. Indem der Wert der Feldstärke in nullter Näherung umgekehrt logarithmisch von der Entfernung Basisstation zu Transponder ist, lässt sich aus der Nummer des Knotens unmittelbar mittels einer Zuordnung der Knotennummer zu einem vorzugsweise in einer Wertetabelle hinterlegtem zugeordneten Entfernungswert eine im Wesentlichen lineare Abhängigkeit zwischen der Nummer des Knotens und der Entfernung erzielen. Hierbei ist es vorteilhaft, wenn der Wert des am Ausgang des Zählers bzw. des Stellgliedes anliegenden Signals vorzugsweise die Nummer des ausgewählten Teilerknotens angibt. Hierdurch lässt sich sowohl bei kleinen als auch bei größeren Abständen zwischen der Basisstation und dem Transponder eine hinreichende Genauigkeit bzw. Auflösung in der Entfernungsbestimmung einstellen. Des Weiteren lässt sich mittels den in der Wertetabelle hinterlegten Werten auch unabhängig von dem gewählten Verhältnis zweier Widerstandswerte der Abstand zwischen Basisstation und Transponder ohne weitere Berechnungen ermitteln. Zusammenfassend lässt sich das Verfahren zur Bestimmung der Feldstärke ohne weiteres in ein Verfahren zur Bestimmung der Entfernung zwischen der Basisstation und Transponder weiterbilden.

In einer anderen Weiterbildung lassen sich durch Wahl von anderen funktionalen Verhältnissen zwischen zwei Widerstandswerten der Spannungsteilerschaltung nichtlineare Abhängigkeiten zwischen den Knotennummern und der Entfernung oder eine lineare Abhängigkeit zwischen der Knotennummer und der Feldstärke einstellen.

Das erfindungsgemäße Verfahren und die erfindungsgemäße Schaltungsanordnung sollen nachfolgend anhand der Ausführungsbeispiele im Zusammenhang mit den schematisierten Zeichnungen erläutert werden. Funktionsgleiche Element weisen in den Figuren gleiche Referenzbezeichnungen auf. Es zeigen,
- Fig. 1: eine Verstärkerschaltung mit einem Spannungsteiler der mittels eines Stellgliedes eine veränderbare Eingangspannung für einen Operationsverstärker bereitstellt,
- Fig. 2: eine Spannungsteilerschaltung mittels einer Reihenschaltung von Widerständen und eine Ansteuerschaltung,
- Fig. 3: eine Spannungsteilerschaltung mittels einer Reihenschaltung und einer Kombination von einer Reihen- und Parallelschaltung von Widerständen,
- Fig. 4: eine Spannungsteilerschaltung mittels einer Reihenschaltung von MOS-Transistoren,
- Fig. 5: ein schematisierter Vergleich der Ortsauflösung gemäß dem erfindungsgemäßen Verfahren und dem Stand der Technik.

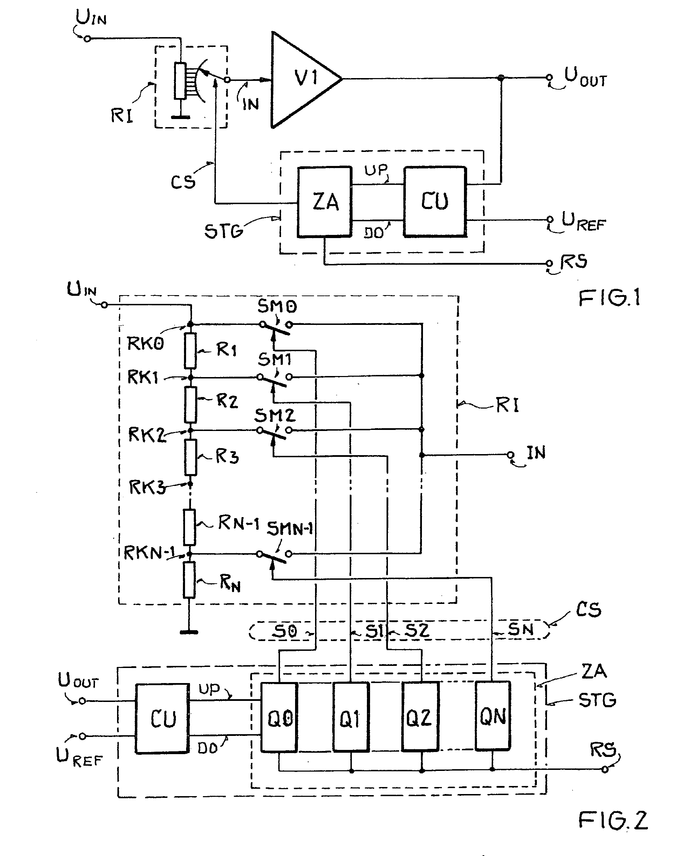

Die Aufgabe der in Figur 1 dargestellten Schaltungsanordnung ist es, ein wechselspannungsförmiges Eingangssignal UIN, das proportional der Feldstärke eines von einer Empfangsantenne (nicht abgebildet) empfangenen elektromagnetischen Signals ist, mittels einer Spannungsteilerschaltung eine Eingangsspannung IN zu erzeugen und eines Operationsverstärkers V1 um einen festen Faktor zu verstärken, so dass das Ausgangssignal UOUT mittels eines Stellgliedes STG, das einen entsprechenden Knoten auswählt und hierbei der Widerstandswert eines als Spannungsteilerschaltung ausgebildeten Eingangswiderstands RI nicht verändert wird, innerhalb eines vorgegebenen Intervalls zu halten. Das Eingangssignal UIN fällt über dem Eingangswiderstand RI vollständig ab.

Die Spannungsteilerschaltung mit einer Vielzahl von Knoten weist einen ersten Anschluss, welcher mit dem Eingangssignal UIN, einen zweiten Anschluss, welcher mit dem Bezugspotential, einen dritten Anschluss, der als Steuereingang ausgebildet und mit dem Stellglied STG verschaltet ist und an dem ein Steuersignal CS anliegt, und einen vierten Anschluss, der mit einem Eingang des Operationsverstärkers V1 verschaltet ist, auf. Des Weiteren weist das Stellglied STG einen Eingang, welcher mit der Ausgangsspannung UOUT verschaltet ist und einen Eingang, an dem eine Referenzspannung UREF anliegt, sowie einen Ausgang zur Ausgabe eines Signals RS, auf. Das Stellglied STG weist eine Kontrolleinheit CU und einen Zähler ZA auf. Die Kontrolleinheit CU, an der die Ausgangsspannung UOUT und die Referenzspannung UREF anliegen, ist mit einer Steuerleitung UP und einer Steuerleitung DO mit einem Zähler ZA, der eine Vielzahl von Bausteinen (nicht abgebildet) aufweist, verschaltet.

Im Folgenden wird die Funktionsweise näher erläutert. Dem Operationsverstärker V1 wird die Eingangsspannung IN aus dem Eingangssignal UIN mittels der Spannungsteilerschaltung zugeführt, indem einer der Knoten der Spannungsteilerschaltung mit dem Operationsverstärker V1 verschaltet wird. Mittels des Steuereingangs und des Steuersignals CS wird bei der Spannungsteilerschaltung von dem Stellglied STG bei einer hohen anliegenden Eingangsspannungen ein Knoten in der Nähe des Bezugspotentials ausgewählt, um die Eingangsspannung IN des Operationsverstärkers V1 soweit abzusenken, bis die Ausgangsspannung UOUT mit einer ebenfalls an dem Eingang des Stellgliedes STG anliegenden Referenzspannung UREF übereinstimmt, insbesondere innerhalb eines um die Referenzspannung UREF aufgespannten Intervalls liegt. Liegt die Ausgangsspannung UOUT unterhalb des Spannungsintervalls, wird von dem Stellglied STG ein Knoten, welcher weiter von dem Bezugspotential entfernt ist, ausgewählt und folglich dessen die Eingangsspannung IN des Operationsverstärkers V1 erhöht. Aus dem jeweils ausgegeben Signal RS lässt sich der zugehörige Feldstärkewert bzw. die Entfernung ermitteln, in dem die in einem Speicher zugeordnete Größe, vorzugsweise ein zugeordneter Feldstärkewert oder höchst vorzugsweise ein zugeordneter Entfernungswert ausgelesen wird. Untersuchungen der Anmelderin haben gezeigt, dass der Feldstärkewert bzw. der Entfernungswert auch ohne Ausbildung eines Speicherbereichs mit den ausgewählten Knoten zugeordneten Werten durch einen Algorithmus, vorzugsweise unter Verwendung eines Prozessors, bestimmbar ist.

In der Figur 2 ist ein Ausführungsbeispiel des als Spannungsteilerschaltung ausgebildeten Eingangswiderstands RI dargestellt. Zwischen dem ersten Anschluss der Spannungsteilerschaltung, an dem die Eingangsspannung UIN anliegt und dem Bezugspotential ist eine Serienschaltung von einzelnen Widerständen R1, R2, R3, bis Rn-1, RN ausgebildet. Zwischen dem Signal UIN und dem Widerstand R1 ist eine Knoten RK0, zwischen dem Widerstand R1 und dem Widerstand R2 ist ein Knoten RK1, zwischen dem Widerstand R2 und dem Widerstand R3 ein Knoten RK2, nach dem Widerstand R3 ein Knoten RK3 und zwischen dem Widerstand RN-1 und dem Widerstand RN ein Knoten RKN-1 ausgebildet.
Der Knoten RK0 lässt sich mittels des steuerbaren Schaltmittels SM0 mit dem Eingang des Operationsverstärkers V1 verschalten. Hierzu ist der Steuereingang des Schaltmittels mit einem Baustein Q0 des Zählers ZA verschaltet und von dem Baustein Q0 wird eine Signal S0 bereitgestellt. Der Knoten RK1 lässt sich mittels des steuerbaren Schaltmittels SM1 mit dem Eingang des Operationsverstärkers V1 verschalten. Hierzu ist der Steuereingang des Schaltmittels SM1 mit einem Baustein Q1 des Zählers ZA verschaltet und von dem Bausteins Q1 wird ein Signals S1 bereitgestellt. Der Knoten RK2 lässt sich mittels des steuerbaren Schaltmittels SM2 mit dem Eingang des Operationsverstärkers V1 verschalten. Hierzu ist der Steuereingang des Schaltmittels SM2 mit einem Baustein Q2 des Zählers ZA verschaltet und von dem Bausteins Q2 wird ein Signals S2 bereitgestellt. Der Knoten RKN-1 lässt sich mittels des steuerbaren Schaltmittels SMN-1 mit dem Eingang des Operationsverstärkers V1 verschalten. Hierzu ist der Steuereingang des Schaltmittels SMN-1 ist einem Baustein QN des Zählers ZA verschaltet und von dem Bausteins QN wird ein Signals SN bereitgestellt.
Von der Kontrolleinheit CU, wird falls die Ausgangsspannung UOUT unterhalb der Referenzspannung UREF liegt, mittels der Steuerleitung DO ein Knoten oberhalb des bisher ausgewählten Knotens, d.h. ein Knoten der näher an der Eingangsspannung UIN liegt, angewählt, indem beispielsweise der Baustein Q2 mittels der Steuerleitung DO desaktiviert wird und für das Schaltmittel SM2 kein entsprechendes Signal S2 zum Schließen des Schaltmittels SM2 zur Verfügung gestellt wird und das Schaltmittel SM2 infolgedessen die Verbindung des Knotens RK2 mit dem Eingang des Operationsverstärker V1 trennt. Von der Kontrolleinheit CU wird mittels der Steuerleitung DO der Baustein Q1 angesteuert und hierdurch mittels des Signals S1 und dem Schaltmittels SM1 der Knoten RK1 mit dem Eingang des Operationsverstärkers V1 verschaltet. Es sei angenommen, dass nunmehr die Ausgangsspannung UOUT innerhalb eines vorgegebenen Intervalls liegt und hierdurch der Regelvorgang beendet ist. Indem von der Kontrolleinheit CU mittels der Steuerleitung der Knoten RK1 ausgewählt wird, wird von der Steuereinheit STG ein entsprechendes Signals RS, das einen geringeren Wert aufweist, ausgegeben. Mittels des Signal RS lässt sich ein entsprechend zugeordneter Feldstärkewert bzw. ein zugeordneter Entfernungswert, der dem anliegenden Eingangssignal entspricht, vorzugsweise aus einer Speichereinheit auslesen, und die Entfernung zwischen der Sendeeinheit und dem Empfangseinheit bestimmt. Hiernach lässt sich der Wert ausgeben und / oder zur Steuerung von Kommunikationsparametern zwischen der Sende- und Empfangseinheit verwenden.
In dem die Werte der einzelnen in Reihe verschalteten Widerstände geeignet gewählt werden, lässt sich die Schrittweite der Spannungsänderungen zwischen den einzelnen Knoten derart festlegen, dass indem jeweiligen Feldstärkebereich bzw. Entfernungsbereich über den gesamt messbaren Bereich eine ausreichende Ortsauflösung gegeben ist.

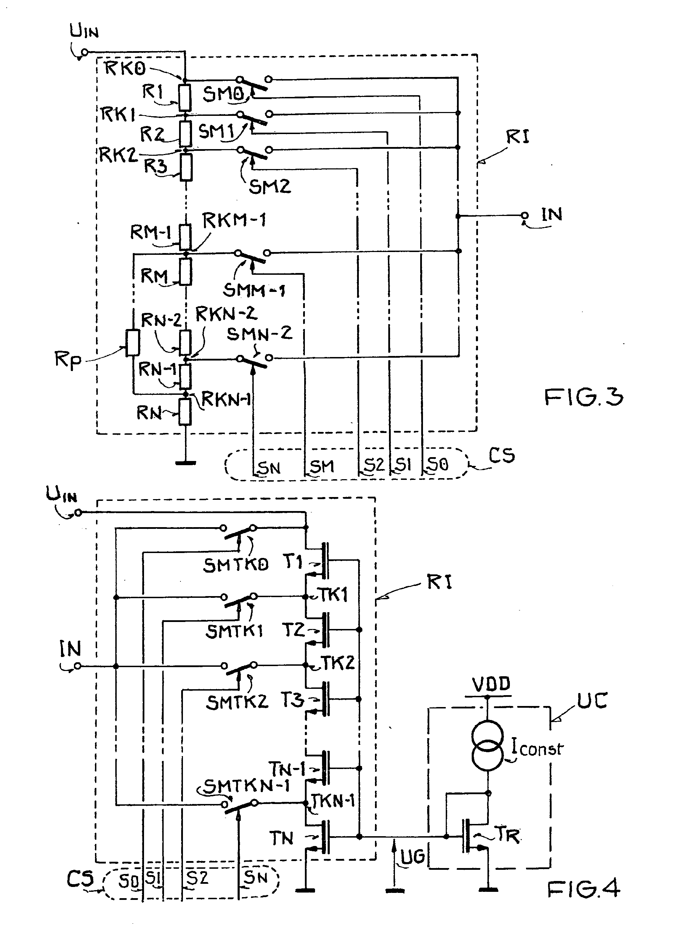

In der Figur 3 ist ein weiteres Ausführungsbeispiel eines als Spannungsteilerschaltung ausgebildeten Eingangswiderstands RI dargestellt. Im Folgenden werden die Unterschiede zu dem in Zusammenhang mit den Zeichnungsunterlagen der Figur 2 erläuterten Ausführungsform ausgeführt. Zwischen dem Widerstand RM-1 und dem Widerstand RM ist ein Knoten RKM-1 ausgebildet. Der Knoten RKM-1 lässt sich mittels des steuerbaren Schaltmittels SMM-1 mit dem Eingang des Operationsverstärkers V1 verschalten. Hierzu ist der Steuereingang des Schaltmittels SMM-1 mit einem Baustein QM (nicht abgebildet) des Zählers ZA verschaltet und von dem Bausteins QM wird ein Signal SM bereitgestellt. Zwischen dem Knoten RKM-1 und dem Knoten RKN-1 ist ein Widerstand RP verschaltet. Mittels der Parallelschaltung des Widerstandes RP lässt sich die Abstufung der Widerstandswerte und damit die Spannungsstufen vorteilhaft beeinflussen. Insbesondere bei einem Abgriff der Spannung an einem Knoten der von dem Widerstand RP parallel geschaltet wird, wird der Widerstand durch die Parallelschaltung erniedrigt.

In der Figur 4 ist eine weitere Ausführungsform des Spannungsteilers als eine Serienschaltung von NMOS-Transistoren dargestellt. Jeder der Transistoren weist einen Ausgang, einen Eingang und einen Steuereingang auf. Die Steuereingänge der Transistoren sind miteinander verschaltet. Gemäß der vorliegenden Ausführungsform lässt sich durch das erste Schaltmittels SMTK0 die anliegende Eingangsspannung UIN dem Eingang des Operationsverstärkers zuführen. Hierzu wird das Schaltmittel SMTK0 mittels des Signals S0 von dem Baustein Q0 angesteuert. Im weiteren Verlauf ist ein Transistor T1 mit einem Transistor T2 unter Ausbildung eines Knotens TK1 verschaltet. Der Knoten TK1 ist mittels eines steuerbaren Schaltmittels SMTK1 mit dem Operationsverstärkers V1 (nicht abgebildet), um die Eingangsspannung IN dem Operationsverstärker V1 zuzuführen, verbunden. Das Schaltmittel SMTK1 weist einen Steuereingang auf, der mit dem Zählerbausteins Q1 (nicht abgebildet) verbunden ist und das Signal S1 anliegt. Der Transistor T2 ist mit einem Transistor T3 unter Ausbildung eines Knotens TK2 verschaltet. Der Knoten TK2 ist mittels eines steuerbaren Schaltmittels SMTK2 mit dem Operationsverstärkers V1 (nicht abgebildet), um die Eingangsspannung IN dem Operationsverstärker V1 zu zuführen, verbunden. Das Schaltmittel SMTK2 weist einen Steuereingang auf, der mit dem Zählerbausteins Q2 (nicht abgebildet) verbunden ist und das Signal S2 anliegt. Der Transistor TN-1 ist mit einem Transistor TN unter Ausbildung eines Knotens TKN-1 verschaltet. Der Knoten TKN-1 ist mittels eines steuerbaren Schaltmittels SMTKN-1 mit dem Operationsverstärkers V1 (nicht abgebildet), um die Eingangsspannung IN dem Operationsverstärker V1 zu zuführen, verbunden. Das Schaltmittel SMTKN-1 weist einen Steuereingang auf, der mit dem Zählerbausteins QN (nicht abgebildet) verbunden ist und das Signal SN anliegt.
Die zusammengeschalteten Steuereingänge der Transistoren T1, T2, T3, .... TN-1, TN sind mit einer Konstantspannungsquelle UC verschaltet. Die Konstantspannungsquelle UC stellt eine Steuerspannung UG bereit und ist mit einer Versorgungsspannung VDD und mit einem Referenzpotential, vorzugsweise einem Massepotential, verschaltet. Zur Erzeugung der Steuerspannung UG weist die Konstantspannungsquelle UC eine Konstantstromquelle Iconst auf, welche in Serie mit einem als Diode verschalteten Transistor TR verbunden ist. Mittels des konstanten Stromes durch die Transistordiode wird die konstante Steuerspannung UG erzeugt.
Untersuchungen der Anmelderin haben gezeigt, dass die Steuerspannung UG der Transistoren vorzugsweise so gewählt wird, dass für den gesamten Spannungsbereich von UIN der Arbeitspunkt der MOS-Transistoren im linearen Bereich des Ausgangskennlinienfeld liegt und hierdurch ein mit einem ohmschen Widerstand vergleichbares Verhalten vorliegt. Durch Ansteuerung des jeweiligen Schaltmittels wird derjenige Knoten ausgewählt, dessen Knotenspannung als Eingangsspannung IN dem Operationsverstärkers V1 zugeführt werden muss, um die Ausgangsspannung UOUT des Operationsverstärkers V1 zumindest in dem geforderten Bereich um die Referenzspannung UREF liegt. Ist diese Bedingung nicht erfüllt wird von dem Stellglied STG ein Knoten ausgewählt, der die genannte Bedingung erfüllt.

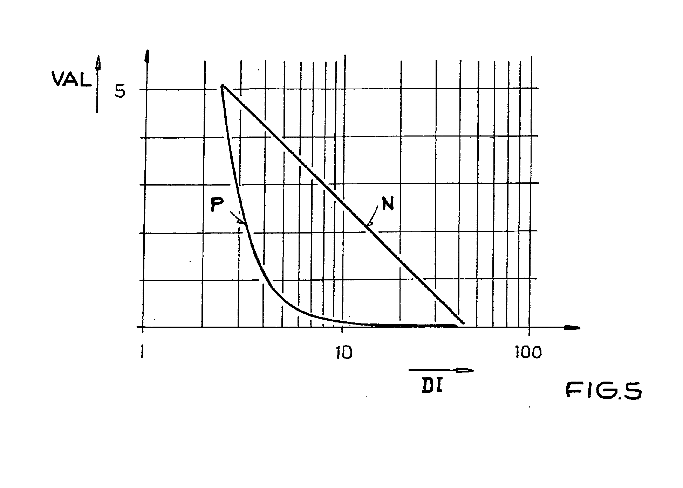

In der Figur 5 ist entlang der Y-Achse in einer linearen Darstellung der Abstand zweier Regelpunkte VAL gemäß der vorliegenden Erfindung über dem Logarithmus der Entfernung DI zwischen einer Sendestation und einer Basisstation entlang der X-Achse aufgetragen, wobei die Werte an den beiden Achsen rein willkürlich gewählt sind. Den Zusammenhang zwischen dem Abstand zweier Teilerknotenspannungswerten und der Entfernung und hierdurch die Ortsauflösung gemäß der vorliegenden Erfindung wird mittels einer Linie N veranschaulicht, während mittels einer Kurve P der Verlauf der Ortsauflösung gemäß dem Stand der Technik, beispielsweise bekannt aus der Druckschrift EP 1 318 623 B1, darstellt wird. Im Unterschied zu dem bisherigen Stand der Technik wird gemäß der vorliegenden Erfindung die Bestimmung der Entfernung auch bei größeren Distanzen zuverlässig und mit wesentlich verbesserter Wertedichte möglich. Letzteres ist im Stand der Technik nur sehr ungenau möglich.

In den bisher angeführten Ausführungsbeispielen lassen sich die dargestellten NMOS-Transistoren auch durch PMOS-Transistoren oder durch Bipolartransistoren ersetzen. Die Ansteuerschaltung der Steuereingänge ist hierzu entsprechend anzupassen. Unter anderem ist bei einer Ausführung mit Bipolartransistoren eine erhöhte Stromaufnahme und die insbesondere bei passiven Transpondern mit verbundener Verringerung der Kommunikationsreichweite nachteilig.

## Patentansprüche

1. Verfahren zur Gewinnung einer Feldstärkeinformation wobei aus einem Signal (UIN) mittels eines als eine Spannungsteilerschaltung ausgebildeten Eingangswiderstands (RI) eine Eingangsspannung (IN) für einen Operationsverstärker (V1) erzeugt wird, und
zur Veränderung der Eingangsspannung (IN) an der Spannungsteilerschaltung, die eine Vielzahl von Teilerknoten (RK0, RK1, TK1, RKM, TKN-1, RKN-1) und einen konstanten Widerstandswert aufweist, ein Teilerknoten (RK0, RK1, TK1, RKM, TKN-1, RKN-1) ausgewählt wird und eine Teilspannung abgegriffen wird, und
• von dem Operationsverstärker (V1) mittels eines festen Verstärkungsfaktor eine Ausgangsspannung (UOUT) erzeugt wird, und
• von einem mit dem Ausgang des Operationsverstärker (V1) verbundenen Stellglied (STG), ein Steuersignal (CS) zur Auswahl der Teilerknoten (RK0, RK1, TK1, RKM, TKN-1, RKN-1) bereitgestellt wird ,wobei das Stellglied (STG) einen Eingang für die Ausgangsspannung (UOUT) aufweist, und
• mit der Auswahl der Teilerknoten (RK0, RK1, TK1, RKM, TKN-1, RKN-1) die Eingangsspannung (IN) verändert wird, bis die Ausgangsspannung (UOUT) innerhalb eines vorgegebenen, Intervalls liegt, und
• die Eingangsspannung (IN) an der Spannungsteilerschaltung abgegriffen wird,
**dadurch gekennzeichnet, dass**
eine Empfangseinheit zum Empfangen des elektromagnetischen Signals vorgesehen ist, und das empfangene Signal als Eingangssignal (UIN) an einen ersten Anschluss der Spannungsteilerschaltung angelegt wird, und
• mittels des Stellglieds (STG), das einen Eingang für eine Referenzspannung (UREF) aufweist zur Veränderung der Eingangsspannung (IN) eine in Abhängigkeit eines Vergleichs der Ausgangsspannung (UOUT) mit der Referenzspannung (UREF) durch das Steuersignal (CS) ein Teilerknoten (RK0 RK1, TK1, RKM, TKN-1, RKN-1) ausgewählt wird, so dass die Referenzspannung (UREF) innerhalb des Intervalls liegt, und
• an einem Ausgang des Stellgliedes (STG) ein dem Steuersignal (CS) zugeordnetes Signal (RS) bereitgestellt wird, wobei der Wert des zugeordneten Signals (RS) von der empfangenen Feldstärke abhängt, und
• jedem Teilerknoten ein vorgegebener Wert einer ersten Variablen zugeordnet ist, und
• aus einem Vergleich des dem ausgewählten Teilerknoten (RK0, RK1, TK1, RKM, TKN-1, RKN-1) zugeordneten Wertes der ersten Variablen mit einem in einer Wertetabelle dem Wert der ersten Variable zugeordneten Feldstärkewert, den von der Empfangseinheit empfangene Feldstärkewert bestimmt wird.

2. Verfahren gemäß Anspruch 1, **dadurch gekennzeichnet, dass** der Abgriff der Teilspannung mittels eines dem Teilerknoten (RK0, RK1, TK1, RKM, TKn-1, RKn-1) zugeordneten steuerbaren Schaltmittels (SM0, SM1, SM2, .... SMN-1, SMTK1, SMTK2, SMTK-1) durchgeführt wird.

3. Verfahren gemäß Anspruch 1 oder Anspruch 2, **dadurch gekennzeichnet, dass** die Ansteuerung des Schaltmittels (SM0, SM1, SM2, ... SMN-1, SMTK1, SMTK2, SMTK-1) mittels eines Ausgangssignal (S1...SN) eines Bauelementes eines Zählers (ZA) bewirkt wird.

4. Verfahren gemäß Anspruch 3, **dadurch gekennzeichnet, dass** an einen Ausgang des Zählers (ZA) ein der empfangenen Feldstärke zugeordnetes Signal (RS) zur Verfügung gestellt wird.

5. Verfahren nach einem der Ansprüche 1 bis 4, **dadurch gekennzeichnet, dass** die Spannungsteilerschaltung als eine Reihenschaltung von einer Vielzahl von Bauelementen ausgeführt wird.

6. Verfahren nach einem der Ansprüche 1 bis 4, **dadurch gekennzeichnet, dass** die Spannungsteilerschaltung aus einer Reihenschaltung von MOS Transistoren (T1, T2, T3.... TN) ausgebildet wird.

7. Schaltungsanordnung zur Durchführung des Verfahrens nach einem der Ansprüche 1 bis 6 aufweisend,
ein als Spannungsteilerschaltung ausgebildeten Eingangswiderstand (RI), wobei die einem konstanten Widerstandswert aufweisende Spannungsteilerschaltung eine Vielzahl von zueinander in Serie liegenden Teilerknoten (RK0, RK1, TK1, RKM, TKN-1, RKN-1) umfasst,
einen Operationsverstärker (V1) mit einem festen Verstärkungsfaktor, wobei der Eingang mit der Spannungsteilerschaltung verbunden ist und der Operationsverstärker (V1) aus einer anliegenden Eingangsspannung (IN) eine Ausgangsspannung (UOUT) bereitstellt,
ein mit dem Ausgang des Operationsverstärker (V1) verbundenes Stellglied (STG), mit einem Eingang für die Ausgangsspannung (UOUT),
**dadurch gekennzeichnet, dass**
• eine Empfangseinheit zum Empfangen eines elektromagnetischen Signals vorgesehen ist, wobei das von einer Empfangsantenne empfangene Signal als Eingangssignal an einen ersten Anschluss der Spannungsteilerschaltung anliegt, und
• das Stellglied (STG) einen Eingang für eine Referenzspannung (UREF) aufweist und eingerichtet ist, zur Veränderung der Eingangsspannung (IN) eine in Abhängigkeit eines Vergleichs der Ausgangsspannung (UOUT) mit der Referenzspannung (UREF) ein Steuersignal (CS) zur Auswahl der Teilerknoten (RK0, RK1, TK1, RKM, TKN-1, RKN-1) bereitzustellen, und
• für die Ermittlung der empfangenen Feldstärke eingerichtet ist, an einem Ausgang ein dem Steuersignal (CS) zugeordnetes Signal (RS) bereitzustellen, wobei der Wert des Signals (RS) von der empfangenen Feldstärke abhängt.

8. Schaltungsanordnung gemäß Anspruch 7, **dadurch gekennzeichnet, dass** die Spannungsteilerschaltung eine dem Teilerknoten (RK0, RK1, TK1, RKM, TKN-1, RKN-1) zugeordnetes steuerbares Schaltmittel (SM0, SM1, SM2, .... SMN-1, SMTK1, SMTK2, SMTK-1) aufweist.

9. Schaltungsanordnung gemäß Anspruch 7 oder Anspruch 8, **dadurch gekennzeichnet, dass** das Stellglied (STG) einen Zähler (ZA) mit wenigstens einem Ausgang zur Ansteuerung des Schaltmittels (SM0, SM1, SM2, .... SMN-1, SMTK1, SMTK2, SMTK-1) mittels eines Ausgangssignal (S1, S2, S3, ... SN) umfasst.

10. Schaltungsanordnung nach einem der Ansprüche 7 bis 9, **dadurch gekennzeichnet, dass** die Spannungsteilerschaltung eine Reihenschaltung mit einer Vielzahl von Bauelementen umfasst.

11. Schaltungsanordnung nach einem der Ansprüche 7 bis 9, **dadurch gekennzeichnet, dass** die Spannungsteilerschaltung eine Reihenschaltung mit einer Vielzahl von MOS Transistoren (T1, T2, T3, ...TN-1, TN) umfasst, wobei die Steuereingänge der MOS Transistoren (T1, T2, T3, ...TN-1, TN) verbunden sind.

12. Schaltungsanordnung nach einem der Ansprüche 7 bis 11, **dadurch gekennzeichnet, dass** Widerstandswerte der Spannungswerte zwischen zwei Teilerknoten ein logarithmisches Verhältnis ausbilden.

13. Schaltungsanordnung nach einem der Ansprüche 7 bis 12, **dadurch gekennzeichnet, dass** der Wert des Signals (RS) die Nummer des ausgewählten Teilerknotens angibt.

## Claims

1. Method of extracting field strength information, whereby an input voltage (IN) for an operational amplifier (V1) is generated from a signal (UIN) via an input resistance (RI) provided in the form of a voltage divider circuit, and
in order to change the input voltage (IN) at the voltage divider circuit, which comprises a plurality of divider nodes (RK0, RK1, TK1, RKM, TKN-1, RKN-1) and has a constant resistance value, a divider node (RK0, RK1, TK1, RKM, TKN-1, RKN-1) is selected and a partial voltage is tapped, and
• an output voltage (UOUT) is generated by the operational amplifier (V1) by means of a fixed amplification factor, and
• a control signal (CS) for selecting the divider nodes (RK0, RK1, TK1, RKM, TKN-1, RKN-1) is supplied by a control element (STG) connected to the output of the operational amplifier (VI), and the control element (STG) has an input for the output voltage (UOUT), and
• by selecting the divider nodes (RK0, RK1, TK1, RKM, TKN-1, RKN-1), the input voltage (IN) is changed until the output voltage (UOUT) lies within a predefined interval, and
• the input voltage (IN) is tapped at the voltage divider circuit,
**characterised in that**
a receiver unit for receiving the electromagnetic signal is provided and the received signal is applied to a first terminal of the voltage divider circuit as an input signal (UIN), and
• by means of the control element (STG), which has an input for a reference voltage (UREF) for changing the input voltage (IN) by means of the control signal (CS) depending on a comparison of the output voltage (UOUT) with the reference voltage (UREF), a divider node (RK0, RK1, TK1, RKM, TKN-1, RKN-1) is selected so that the reference voltage (UREF) lies within the interval, and
• a signal (RS) assigned to the control signal (CS) is supplied at an output of the control element (STG), and the value of the assigned signal (RS) depends on the received field strength, and
• a predefined value of a first variable is assigned to every divider node, and
• the field strength value received by the receiver unit is determined by means of a comparison of the value of the first variable assigned to the selected divider node (RK0, RK1, TK1, RKM, TKN-1, RKN-1) with a field strength value assigned to the value of the first variable in a table of values.

2. Method as claimed in claim 1, **characterised in that** the partial voltage is tapped by means of a controllable switching means (SM0, SM1, SM2, ... SMN-1, SMTK1, SMTK2, SMTK-1) assigned to the divider node (RK0, RK1, TK1, RKM, TKN-1, RKN-1).

3. Method as claimed in claim 1 or 2, **characterised in that** the switching means (SM0, SM1, SM2, ... SMN-1, SMTK1, SMTK2, SMTK-1) is activated by means of an output signal (S1 ... SN) of a component of a counter (ZA).

4. Method as claimed in claim 3, **characterised in that** a signal (RS) assigned to the received field strength is made available at an output of the counter (ZA).

5. Method as claimed in one of claims 1 to 4, **characterised in that** the voltage divider circuit is configured as a series connection of a plurality of components.

6. Method as claimed in one of claims 1 to 4, **characterised in that** the voltage divider circuit comprises a series connection of MOS transistors (T1, T2, T3,... TN).

7. Circuit arrangement for implementing the method as claimed in one of claims 1 to 6, comprising
an input resistance (RI) provided in the form of a voltage divider circuit, which divider circuit, having a constant resistance value, comprises a plurality of divider nodes (RK0, RK1, TK1, RKM, TKN-1, RKN-1) connected in series with one another,
an operational amplifier (V1) with a fixed amplification factor, the input of which is connected to the voltage divider circuit, and the operational amplifier (V1) supplies an output voltage (UOUT) from a prevailing input voltage (IN),
a control element (STG) connected to the output of the operational amplifier (V1) having an input for the output voltage (UOUT),
**characterised in that**
• a receiver unit for receiving an electromagnetic signal is provided, and the signal received by a receiving antenna is applied to a first terminal of the voltage divider circuit as an input signal, and
• the control element (STG) has an input for a reference voltage (UREF) and is set up so as to supply a control signal (CS) for selecting the divider nodes (RK0, RK1, TK1, RKM, TKN-1, RKN-1) in order to change the input voltage (IN) depending on a comparison of the output voltage (UOUT) with the reference voltage (UREF), and
• in order to determine the received field strength, is set up so as to supply a signal (RS) assigned to the control signal (CS) at an output, and the value of the signal (RS) depends on the received field strength.

8. Circuit arrangement as claimed in claim 7, **characterised in that** the voltage divider circuit has a controllable switching means (SM0, SM1, SM2, ... SMN-1, SMTK1 , SMTK2, SMTK-1) assigned to the divider node (RK0, RK1, TK1, RKM, TKN-1, RKN-1).

9. Circuit arrangement as claimed in claim 7 or claim 8, **characterised in that** the control element (STG) comprises a counter (ZA) with at least one output for activating the switching means (SM0, SM1, SM2, ... SMN-1, SMTK1, SMTK2, SMTK-1) by means of an output signal (S1, S2, S3, ...SN).

10. Circuit arrangement as claimed in one of claims 7 to 9, **characterised in that** the voltage divider circuit comprises a series connection with a plurality of components.

11. Circuit arrangement as claimed in one of claims 7 to 9, **characterised in that** the voltage divider circuit comprises a series connection with a plurality of MOS transistors (T1, T2, T3, ... TN-1, TN), and the control inputs of the MOS transistors (T1, T2, T3, ... TN-1, TN) are interconnected.

12. Circuit arrangement as claimed in one of claims 7 to 11, **characterised in that** resistance values of the voltage values between two divider nodes form a logarithmic ratio.

13. Circuit arrangement as claimed in one of claims 7 to 12, **characterised in that** the value of the signal (RS) specifies the number of the selected divider node.

## Revendications

1. Procédé de production d'une information d'intensité de champ, d'après lequel
à partir d'un signal (UIN), on produit une tension d'entrée (IN) pour un amplificateur opérationnel (V1), au moyen d'une résistance d'entrée (RI) réalisée en tant que circuit diviseur de tension, et
pour modifier la tension d'entrée (IN), on sélectionne sur le circuit diviseur de tension, qui présente une pluralité de noeuds de diviseur (RK0, RK1, TK1, RKM, TKN-1, RKN-1) et une valeur de résistance constante, un noeud de diviseur (RK0, RK1, TK1, RKM, TKN-1, RKN-1), et on prélève une tension partielle, et
• l'amplificateur opérationnel (V1) moyennant un facteur d'amplification fixe, produit une tension de sortie (UOUT), et
• un organe de réglage (STG) relié à la sortie de l'amplificateur opérationnel (V1) fournit un signal de commande (CS) pour la sélection des noeuds de diviseur (RK0, RK1, TK1, RKM, TKN-1, RKN-1), l'organe de réglage (STG) présentant une entrée pour la tension de sortie (UOUT), et
• la tension d'entrée (IN) est modifiée avec la sélection des noeuds de diviseur (RK0, RK1, TK1, RKM, TKN-1, RKN-1) jusqu'à ce que la tension de sortie (UOUT) se situe à l'intérieur d'un intervalle prédéterminé, et
• la tension d'entrée (IN) est prélevée sur le circuit diviseur de tension,
**caractérisé en ce que**
il est prévu une unité de réception pour la réception d'un signal électromagnétique, et le signal reçu est appliqué en tant que signal d'entrée (UIN) à une première borne de raccordement du circuit diviseur de tension, et
• au moyen de l'organe de réglage (STG), qui présente une entrée pour une tension de référence (UREF), pour modifier la tension d'entrée (IN), le signal de commande (CS) sélectionne un noeud de diviseur (RK0, RK1, TK1, RKM, TKN-1, RKN-1) en fonction d'une comparaison de la tension de sortie (UOUT) avec la tension de référence (UREF), de sorte que la tension de référence (UREF) se situe à l'intérieur de l'intervalle, et
• un signal (RS) associé au signal de commande (CS) est fourni à une sortie de l'organe de réglage (STG), la valeur du signal associé (RS) dépendant de l'intensité de champ reçue, et
• à chaque noeud de diviseur est associée une valeur prédéterminée d'une première variable, et
• l'on détermine la valeur de l'intensité de champ reçue par l'unité de réception, à partir d'une comparaison de la valeur de la première variable associée au noeud de diviseur (RK0, RK1, TK1, RKM, TKN-1, RKN-1) sélectionné, avec une valeur d'intensité de champ associée à la valeur de la première variable dans un tableau de valeurs.

2. Procédé selon la revendication 1, **caractérisé en ce que** le prélèvement de la tension partielle est effectué à l'aide d'un moyen de commutation (SM0, SM1, SM2, ... SMN-1, SMTK1, SMTK2, SMTK-1) pouvant être commandé et associé au noeud de diviseur (RK0, RK1, TK1, RKM, TKN-1, RKN-1).

3. Procédé selon la revendication 1 ou la revendication 2, **caractérisé en ce que** la commande du moyen de commutation (SM0, SM1, SM2, ... SMN-1, SMTK1, SMTK2, SMTK-1) est produite à l'aide d'un signal de sortie (S1 ... SN) d'un composant d'un compteur (ZA).

4. Procédé selon la revendication 3, **caractérisé en ce qu'**un signal (RS) associé à l'intensité de champ reçue est mis à disposition à une sortie du compteur (ZA).

5. Procédé selon l'une des revendications 1 à 4, **caractérisé en ce que** le circuit diviseur de tension est réalisé en tant que circuit série d'une pluralité de composants.

6. Procédé selon l'une des revendications 1 à 4, **caractérisé en ce que** le circuit diviseur de tension est formé par un circuit série de transistors MOS (T1, T2, T3, ... TN).

7. Agencement de circuit pour la mise en oeuvre du procédé selon l'une des revendications 1 à 6, comprenant :
une résistance d'entrée (RI) réalisée en tant que circuit diviseur de tension, le circuit diviseur de tension, qui présente une valeur de résistance constante, comprenant une pluralité de noeuds de diviseur (RK0, RK1, TK1, RKM, TKN-1, RKN-1) en série les uns avec les autres,
un amplificateur opérationnel (V1) avec un facteur d'amplification fixe, l'entrée étant reliée au circuit diviseur de tension et l'amplificateur opérationnel (V1) fournissant, à partir d'une tension d'entrée (IN) appliquée, une tension de sortie (UOUT),
un organe de réglage (STG) relié à la sortie de l'amplificateur opérationnel (V1), et comportant une entrée pour la tension de sortie (UOUT),
**caractérisé en ce que**
• il est prévu une unité de réception pour la réception d'un signal électromagnétique, le signal reçu par une antenne de réception étant appliqué en tant que signal d'entrée à une première borne de raccordement du circuit diviseur de tension, et
• l'organe de réglage (STG) présente une entrée pour une tension de référence (UREF) et, en vue de modifier la tension d'entrée (IN), est conçu pour fournir, en fonction d'une comparaison de la tension de sortie (UOUT) avec la tension de référence (UREF), un signal de commande (CS) pour sélectionner les noeuds de diviseur (RK0, RK1, TK1, RKM, TKN-1, RKN-1), et
• en vue de déterminer l'intensité de champ reçue, est conçu pour fournir à une sortie, un signal (RS) associé au signal de commande (CS), la valeur du signal (RS) dépendant de l'intensité de champ reçue.

8. Agencement de circuit selon la revendication 7, **caractérisé en ce que** le circuit diviseur de tension comprend un moyen de commutation (SM0, SM1, SM2, ... SMN-1, SMTK1, SMTK2, SMTK-1) pouvant être commandé et associé au noeud de diviseur (RK0, RK1, TK1, RKM, TKN-1, RKN-1).

9. Agencement de circuit selon la revendication 7 ou la revendication 8, **caractérisé en ce que** l'organe de réglage (STG) comprend un compteur (ZA) avec au moins une sortie pour commander le moyen de commutation (SM0, SM1, SM2, ... SMN-1, SMTK1, SMTK2, SMTK-1) à l'aide d'un signal de sortie (S1, S2, S3, ... SN).

10. Agencement de circuit selon l'une des revendications 7 à 9, **caractérisé en ce que** le circuit diviseur de tension comprend un circuit série avec une pluralité de composants.

11. Agencement de circuit selon l'une des revendications 7 à 9, **caractérisé en ce que** le circuit diviseur de tension comprend un circuit série avec une pluralité de transistors MOS (T1, T2, T3, ... TN-1, TN), les entrées de commande des transistors MOS (T1, T2, T3, ... TN-1, TN) étant reliées.

12. Agencement de circuit selon l'une des revendications 7 à 11, **caractérisé en ce que** des valeurs de résistance des valeurs de tension entre deux noeuds de diviseur forment un rapport logarithmique.

13. Agencement de circuit selon l'une des revendications 7 à 12, **caractérisé en ce que** la valeur du signal (RS) indique le numéro du noeud de diviseur sélectionné.
